(19) Europäisches Patentamt
European Patent Office
Office européen des brevets

(11) **EP 2 485 288 A1**

(12) **EUROPEAN PATENT APPLICATION**

(43) Date of publication:
**08.08.2012 Bulletin 2012/32**

(51) Int Cl.:
***H01L 45/00*** *(2006.01)*

(21) Application number: **12000385.0**

(22) Date of filing: **23.01.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **07.02.2011 EP 11000964**

(71) Applicant: **Penev, Milen**
**8953 Dietikon (CH)**

(72) Inventor: **Penev, Milen**
**8953 Dietikon (CH)**

(54) **High efficiency energy source**

(57) The invention concerns a high efficiency energy source using quantum mechanics approach, a tunnelling battery (100) and comprises a metal or semiconductor plate, an injector or anode (3), a cathode (4) and a control plate (2), placed in parallel, wherein a thin dielectric layer (5) is placed between anode (3) and cathode (4) and a dielectric layer (6) is placed between cathode (4) and control plate (2). The tunneling battery (100) also comprises an anode terminal (7), electrically connected to anode plate (3), and a cathode terminal (8) of the tunneling battery is electrically connected with the cathode plate (4).

Fig. 2

EP 2 485 288 A1

**Description**

The invention concerns a high efficiency energy source used as electrical battery, suitable for industrial and private purpose.

Conventional energy sources are based on chemical processes by conversion of the stored chemical energy into electrical energy, physical processes, for example photovoltaic, Peltier elements, etc. and nuclear processes, for example opto-electric or micro- nuclear battery.

The object of the present invention is to provide a energy source of different type with higher efficiency.

The proposed high efficiency energy source is based on the Quantum Mechanics process of the electron tunneling.

The electron tunneling inside a dialectical material can be predicted by the Fowler-Nordheim formula:

$$J = a\phi^{-1}F^2\exp[-v(f)\, b\phi^{3/2}/F] \tag{1}$$

, wherein J is the current density of the tunneling electrons current and:

$$a \approx 1.541434 \times 10^{-6}\ \mathrm{A\ eV\ V^{-2}}; \quad b \approx 6.830890\ \mathrm{eV^{-3/2}\ V\ nm^{-1}}$$

$$v(f) \approx 1 - f + (1/6)f\ln f$$

$$f = F/F_\phi = (e^3/4\pi\epsilon_0)(F/\phi^2) = (1.439964\ \mathrm{eV^2\ V^{-1}\ nm})(F/\phi^2)$$

The high efficiency energy source using quantum mechanics approach comprises three metal, semiconductor plates: Injector (anode), cathode and control plate.

All three plates are placed in parallel to each other at some distance between themselves in form of a sandwich. The Cathode is placed in the middle. Between the Cathode and the Injector is placed a thin dielectric layer.

The distance between the Control plate and Cathode is bigger than the distance between the Injector and the Cathode. Between the Cathode and the Control plate another dielectric layer is placed. These three plates and the two dialectical layers have physical contact.

The high efficiency energy source comprises also a standard high voltage (~20V) voltage source. The Cathode of the high voltage source is connected electrically with the Injector plate.

The Anode of the high voltage source is connected to the Control plate of the high efficiency energy source.

The Injector and Cathode plates of the high efficiency energy source are wired to the corresponding output terminals of the high efficiency energy source.

For more complete description of the present invention and its advantages, reference is made to the following description, taken in conjunction with the accompanying drawings, in which

Fig. 1: disclose a cross-section view of the high efficiency energy source using quantum mechanics approach,

Fig. 2: shows the electron flows when a load is connected to the source,

Fig. 3: shows equivalent electrical schematic of the proposed invention.

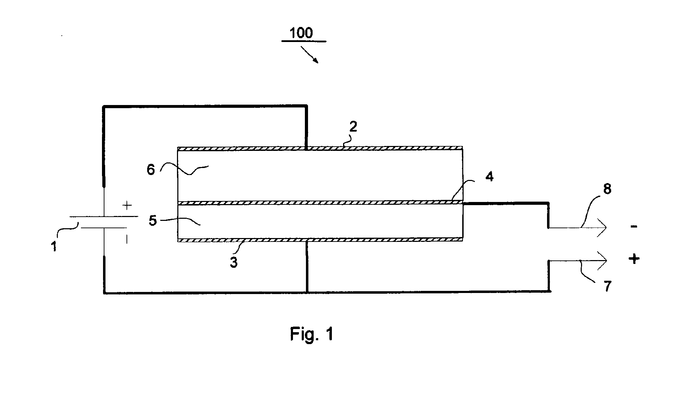

An embodiment of the invention is presented in Fig.1. The high efficiency energy source using quantum mechanics approach 100 comprises a first metal or semiconductor plate, said injector (anode) 3. It can have upper surface processed by nano- or micro-technology in the way that a multiplicity of sharp needles are created what will increase the electric field and the tunnelling current density. On the top of the injector 3 a thin dielectric layer 5 is placed. On the top of the dielectric layer 5 another metal or semiconductor plate, called cathode 4 is placed.

On the top of the cathode 4 a dielectric layer 6 is placed. On the top of the mentioned dielectric layer 6 a third metal or semiconductor plate, said control plate 2 is placed.

The anode terminal 7 of the energy source is electrically connected with the anode plate 3. The cathode terminal 8 of the energy source is electrically connected with the cathode plate 4.

The high efficiency energy source comprises also a high voltage battery 1. The negative terminal of the battery 1 is electrically connected to the anode plate 3. The positive terminal of the battery 1 is electrically connected to the control plate 2 of the high efficiency energy source using quantum mechanics approach.

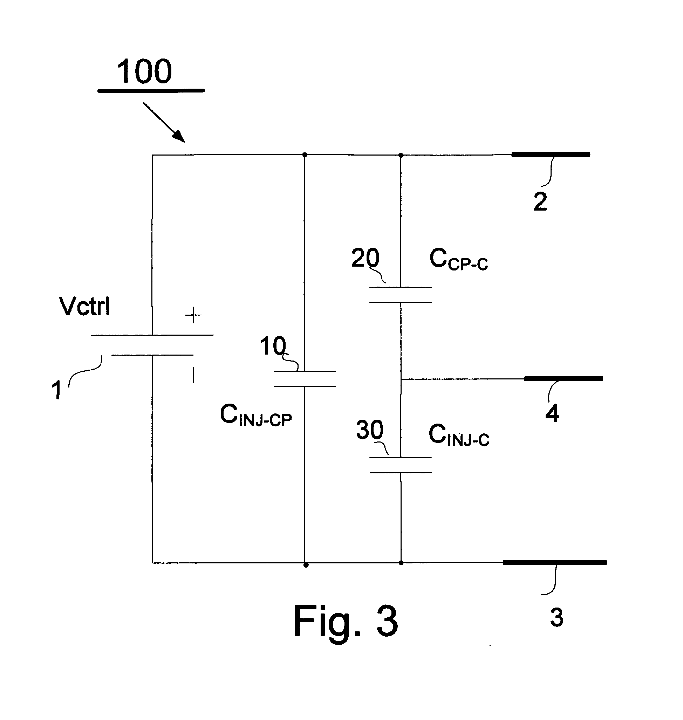

According to the Fig. 3 equivalent electrical schematics of the high efficiency energy source using quantum mechanics approach can be presented. It contains four electrical components:

1) the voltage source (battery) 1, representing the high voltage energy source 1 from Fig. 1
2) the capacitor CINJ_CP 10 emulating the capacitance between the injector 3 and the control plate 2
3) the capacitor CCP_C 20 emulating the capacitance between the cathode 4 and the control plate 2
4) the capacitor CINJ_C 30 emulating the capacitance between the injector 3 and the cathode 4.

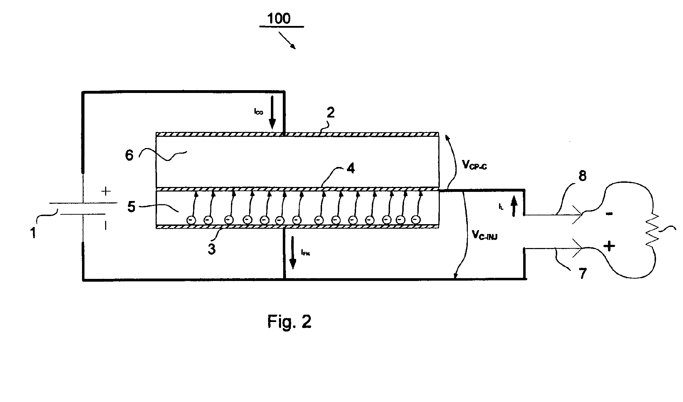

The term IC G in Fig. 2 refers to current compensating the change in the charge of CC P-C, IFN refers to Fowler-Nordheim Current and IL to load current.

The principle of work of the proposed invention will be explained by use of the equivalent electrical schematics (Fig. 3 and Fig. 2), wherein the electron current flows are shown.

At the beginning no load 9 is connected to the high efficiency energy source. The connecting of the high voltage battery 1 between the injector 3 and the control plate 2 causes that the current IFN starts to flow (Fig. 2). It starts to charge the capacitance CINJ-C -, the potential |VC-INJ| at the cathode plate 4 becomes negative and increases with the time.

Because the stored charge at the cathode plate 4 increases and this plate is also bottom plate of the capacitor CCP-C 20 (Fig. 3), a current ICG from the battery 1 starts to flow.

It can be mathematically presented by the formula:

$$I\ CG\ =\ C\ CP\ -\ C\ *\ d(|VCTRL|+|VC\text{-}INJ|)/dt \qquad\qquad (2)$$

, wherein VCTRL is the battery voltage.

If the voltage VC-INJ reaches some desired value, Vbat connect a resistive load 9 between the injector 3 and the cathode 4. The resistance value R is calculated in the way that the load current IL=Vbat/R is fully identical with the current ICG. Then all electrons, which have tunnelled from the Injector to the cathode 4, will go in the load 9.

The charge of the three capacitors will stay constant. Vbat also will be constant. This will keep the voltage VCP-G constant. The current ICG will stop to flow. No power will be consumed from the high voltage battery 1, but energy will be dissipated in the load.

**Claims**

1. High efficiency energy source using quantum mechanics approach,
   **characterised in that** a tunnelling battery (100) comprises a metal or semiconductor plate, an injector or anode (3), a cathode (4) and a control plate (2), placed in parallel, wherein a thin dielectric layer (5) is placed between anode (3) and cathode (4) and a dielectric layer (6) is placed between cathode (4) and control plate (2).

2. High efficiency energy source according to claim 1, wherein the tunneling battery also comprises an anode terminal (7), electrically connected to anode plate (3), and a cathode terminal (8) of the tunneling battery is electrically connected with the cathode plate (4).

3. High efficiency energy source according to claim 1 or 2, wherein the tunneling battery comprises a high voltage battery (1), said trigger source.

4. High efficiency energy source according to claim 3, wherein a cathode of the trigger source is electrically connected to the anode plate (3), and wherein an anode of the trigger source is electrically connected to the control plate (2) of the tunneling battery.

5. High efficiency energy source according to at least one of the claims 1 to 4, wherein a load (9) is connected between terminals (7, 8) of said anode (3) and cathode (4).

6. High efficiency energy source according to claim 1, wherein the injector (3) of the tunneling battery (100) comprises a surface, being processed by nano- or micro-technology in the way that multiplicity of needle shaped formations are created to increase the tunneling effect.

7. Tunneling battery (100) of claim 6, comprising a trigger source of claim 1 or 4, replaceable after the connection of the load (9) by DC/DC boost converter supplied by the tunneling battery (100).

EP 2 485 288 A1

Fig. 1

5

Fig. 2

**Fig. 3**

EP 2 485 288 A1

**EUROPEAN SEARCH REPORT**

Application Number

EP 12 00 0385

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 121 177 A (DAVIS ROBERT H) 11 February 1964 (1964-02-11) * figure 1 * ----- | 1-5,7 | INV. H01L45/00 |
| X | US 3 056 073 A (MEAD CARVER A) 25 September 1962 (1962-09-25) * figure 8 * ----- | 1-5,7 | |
| X | FR 1 422 554 A (IBM) 24 December 1965 (1965-12-24) * figure 2A * ----- | 1-5,7 | |

|  |  |
|---|---|
|  | TECHNICAL FIELDS SEARCHED (IPC) |
|  | H01L H01J H02M |

The present search report has been drawn up for all claims

| Place of search | Date of completion of the search | Examiner |
|---|---|---|
| Munich | 21 June 2012 | Koskinen, Timo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**ANNEX TO THE EUROPEAN SEARCH REPORT
ON EUROPEAN PATENT APPLICATION NO.** EP 12 00 0385

This annex lists the patent family members relating to the patent documents cited in the above-mentioned European search report.
The members are as contained in the European Patent Office EDP file on
The European Patent Office is in no way liable for these particulars which are merely given for the purpose of information.

21-06-2012

| Patent document cited in search report | Publication date | Patent family member(s) | Publication date |
|---|---|---|---|
| US 3121177 A | 11-02-1964 | NONE | |
| US 3056073 A | 25-09-1962 | NONE | |
| FR 1422554 A | 24-12-1965 | NONE | |

EPO FORM P0459